# EUROPEAN PATENT APPLICATION

(11) **EP 3 355 367 A1**
(43) Date of publication of application: **01.08.2018**
(21) Application number: 16848983.9
(22) Date of filing: 23.09.2016
(51) Int. Cl.: H01L 33/20, H01L 33/36, H01L 33/62

(54) **LIGHT EMITTING ELEMENT AND LIGHT EMITTING APPARATUS COMPRISING SAME**

(30) Priority: 24.09.2015 KR 20150135268
(71) Applicant: Seoul Viosys Co. Ltd., Ansan-si, Gyeonggi-do 15429 (KR)
(72) Inventor: LEE, Keum Ju, Ansan-si Gyeonggi-do 15429 (KR); LEE, Seom Geun, Ansan-si Gyeonggi-do 15429 (KR); YUN, Jun Ho, Ansan-si Gyeonggi-do 15429 (KR); GWAK, Woo Chul, Ansan-si Gyeonggi-do 15429 (KR); JANG, Sam Seok, Ansan-si Gyeonggi-do 15429 (KR)
(74) Representative: Stolmár & Partner Patentanwälte PartG mbB
(86) International application number: PCT/KR2016/010638
(87) International publication number: WO 2017/052258

(57) **Abstract**

A light emitting element and a light emitting apparatus are provided. The light emitting element, which has a first side and a second side having a shorter length than the first side, comprises: a substrate including protrusions formed on the upper surface thereof; and a light emitting structure located on the substrate, wherein the protrusions are disposed in a honeycomb pattern and include a first protrusion and second to seventh protrusions which are adjacent to the first protrusion and spaced equidistant from the first protrusions; wherein the angle between a first vector line extending in a direction from the center of the first protrusion toward the center of the second protrusion and a second vector line extending in a direction from the center of the first protrusion to the center of the fourth projection is 120°, the angle between the second vector line and the third vector line extending in a direction from the center of the first projection to the center of the sixth protrusion is 120°; and the angle θ between the first side surface and at least one vector line of the first vector line to the third vector line is 15° or greater and 45° or less.

## Description

### [Technical Field]

The present disclosure relates to a light emitting device and a light emitting apparatus including the same, and more particularly, to a light emitting device including a substrate including protrusions arranged with predetermined orientation and a light emitting apparatus including the same.

### [Background Art]

A light emitting device formed of a nitride-based semiconductor may be provided on a growth substrate on which a nitride-based semiconductor is to be epitaxially grown. A nitride-based semiconductor may be grown on a heterogeneous substrate such as a sapphire substrate, a SiC substrate, a silicon substrate, and a ZnO substrate or a homogeneous substrate such as a GaN substrate. In particular, sapphire has a very high melting point and high durability against wet etch and is inexpensive, and thus, is widely used as a growth substrate of a nitride-based semiconductor.

Recently, a patterned sapphire substrate (PSS) with predetermined patterns formed by patterning a surface of such a sapphire substrate has been used as a growth substrate for manufacture of a light emitting device. Patterns of a PSS enhance light extraction efficiency of a light emitting device and develop an epitaxial growth process of a nitride-based semiconductor to enhance crystalline properties.

### [Disclosure]

### [Technical Problem]

An object of the present disclosure is to provide a light emitting device in which a plurality of protrusions of substrates (e.g., a patterned sapphire substrate (PSS)) has predetermined orientation to enhance luminous efficiency.

Another object of the present disclosure is to provide a light emitting apparatus with a specific relationship between a direction of orienting a plurality of protrusions and a direction of arranging a light emitting device to enhance luminous efficiency.

### [Technical Solution]

According to an aspect of the present disclosure, a light emitting device including a first lateral surface and a second lateral surface with a shorter length than the first lateral surface, includes a substrate including a plurality of protrusions formed on an upper surface thereof, and a light emitting structure disposed on the substrate and including a first conductivity type semiconductor layer, a second conductivity type semiconductor layer, and an active layer disposed between the first and second conductivity type semiconductor layers, wherein the plurality of protrusions are arranged in a honeycomb pattern and include a first protrusion and second to seventh protrusions adjacent to the first protrusion and spaced apart from the first protrusion by the same distance, wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line, wherein an angle between the first vector line and the second vector line is 120° and an angle between the second vector line and the third vector line is 120°, and wherein an angle θ between at least one of the first to third vector lines and the first lateral surface is equal to or greater than 15° and equal to or less than 45°.

According to another aspect of the present disclosure, a light emitting apparatus includes a body including a base and a side wall, first and second lead frames fixed to the body, and a light emitting device disposed on the base and including a first lateral surface and a second lateral surface with a shorter length than the first lateral surface, wherein the light emitting device includes a substrate including a plurality of protrusions formed on an upper surface thereof, and a light emitting structure disposed on the substrate and including a first conductivity type semiconductor layer, a second conductivity type semiconductor layer, and an active layer disposed between the first and second conductivity type semiconductor layers, wherein the plurality of protrusions are arranged in a honeycomb pattern and include a first protrusion and second to seventh protrusions adjacent to the first protrusion and spaced apart from the first protrusion by the same distance, wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line, wherein an angle between the first vector line and the second vector line is 120° and an angle between the second vector line and the third vector line is 120°, and wherein an angle θ between at least one of the first to third vector lines and the first lateral surface is equal to or greater than 15° and equal to or less than 45°.

### [Advantageous Effects]

According to exemplary embodiments, a plurality of protrusions may have orientation with a predetermined angle based on a relationship with a relatively long lateral surface of a light emitting device to increase an amount of light emitted to a relatively long lateral surface of the light emitting device. In addition, a light emitting apparatus including a light emitting device may have excellent luminous efficiency through an arrangement relationship between wirings and electrodes of the light emitting device.

### [Description of Drawings]

FIGS. 1 to 3 are a perspective view, a plan view, and a cross-sectional view illustrating a light emitting apparatus according to an exemplary embodiment of the present disclosure, respectively.
FIGS. 4 to 6 are a plan view and cross-sectional views illustrating a light emitting device and light emitting apparatus according to an exemplary embodiment of the present disclosure, respectively.
FIGS. 7 to 12 are schematic diagrams illustrating orientation and arrangement of protrusions of a substrate according to exemplary embodiments of the present disclosure.
FIGS. 13 to 15 are a perspective view, a plan view, and a cross-sectional view illustrating a light emitting apparatus according to another exemplary embodiment of the present disclosure.
FIGS. 16 and 17 are a plan view and a cross-sectional view illustrating a light emitting apparatus according to another exemplary embodiment of the present disclosure.

### [Best Mode]

A light emitting device and a light emitting apparatus according to exemplary embodiments of the present embodiment may be embodied in various forms.

A light emitting device including a first lateral surface and a second lateral surface with a shorter length than the first lateral surface according to various aspects of the present disclosure, includes a substrate including a plurality of protrusions formed on an upper surface thereof, and a light emitting structure disposed on the substrate and including a first conductivity type semiconductor layer, a second conductivity type semiconductor layer, and an active layer disposed between the first and second conductivity type semiconductor layers, wherein the plurality of protrusions is arranged in a honeycomb pattern and include a first protrusion and second to seventh protrusions adjacent to the first protrusion and spaced apart from the first protrusion by the same distance, wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line, wherein an angle between the first vector line and the second vector line is 120° and an angle between the second vector line and the third vector line is 120°, and wherein an angle θ between at least one of the first to third vector lines and the first lateral surface is equal to or greater than 15° and equal to or less than 45°.

The angle θ may be 30°.

The protrusions may have a conical shape with a circular lower surface or a circular conical shape.

Linear density of protrusions per unit length of the first to third vector lines may be greater than linear density of protrusions per unit length of an arbitrary parallel line to the first lateral surface.

The light emitting device may further include a first electrode electrically connected to the first conductivity type semiconductor layer and a second electrode electrically connected to the second conductivity type semiconductor layer.

The first electrode may include a first electrode pad and the second electrode may include a second electrode pad, and one of the first electrode pad and the second electrode pad may be positioned adjacently to the second lateral surface.

The light emitting device may have a rectangular planar shape.

The substrate including the protrusions may be a patterned sapphire substrate.

A light emitting apparatus according to various aspects of the present disclosure includes a body including a base and a side wall, first and second lead frames fixed to the body, and a light emitting device disposed on the base and including a first lateral surface and a second lateral surface with a shorter length than the first lateral surface, wherein the light emitting device includes a substrate including a plurality of protrusions formed on an upper surface thereof, and a light emitting structure disposed on the substrate and including a first conductivity type semiconductor layer, a second conductivity type semiconductor layer, and an active layer disposed between the first and second conductivity type semiconductor layers, wherein the plurality of protrusions are arranged in a honeycomb pattern and include a first protrusion and second to seventh protrusions adjacent to the first protrusion and spaced apart from the first protrusion by the same distance, wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line, wherein an angle between the first vector line and the second vector line is 120° and an angle between the second vector line and the third vector line is 120°, and wherein an angle θ between at least one of the first to third vector lines and the first lateral surface is equal to or greater than 15° and equal to or less than 45°.

The angle θ may be 30°.

Linear density of protrusions per unit length of the first to third vector lines may be greater than linear density of protrusions per unit length of an arbitrary parallel line to the first lateral surface.

The light emitting device may further include a first electrode electrically connected to the first conductivity type semiconductor layer and a second electrode electrically connected to the second conductivity type semiconductor layer, the first electrode may include a first electrode pad and the second electrode may include a second electrode pad, and one of the first electrode pad and the second electrode pad may be positioned adjacently to the second lateral surface.

The light emitting apparatus may further include a wiring configured to electrically connect at least one of the first and second electrode pads to at least one of the first and second lead frames.

The wiring may extend toward one of the first and second lead frames from one of the first and second electrode pads, and the wiring may extend through an upper space of the second lateral surface.

The light emitting apparatus may include a plurality of light emitting devices, and a first lateral surface of one of the plurality of light emitting devices and a first lateral surface of another one of the plurality of light emitting devices may be arranged in parallel to each other.

The side wall may include a protrusion that protrudes toward a central portion of the body, and the protrusion may protrude toward a space between the plurality of light emitting devices.

In some embodiments, the body may have a long cavity surrounded and fixed by the side wall. The first lateral surface of the light emitting device may be arranged in a length direction of the cavity.

The side wall of the body may include relatively long first and third side walls and relatively short second and fourth side walls; and an inclination of the first and third side walls may be sharper than an inclination surface of the second and fourth side walls.

Hereinafter, exemplary embodiments of the present disclosure will be described in detail with reference to the accompanying drawings. The following embodiments are provided by way of example so as to fully convey the spirit of the present disclosure to those skilled in the art to which the present disclosure pertains. Accordingly, the present disclosure is not limited to these embodiments disclosed herein and may also be implemented in different forms. In the drawings, widths, lengths, thicknesses, and the like of an element can be exaggerated for clarity and descriptive purposes.. When an element is referred to as being "disposed above" or "disposed on" another element, it can be directly "disposed above" or "disposed on" the other element, or intervening elements can be present. Throughout the specification, like reference numerals denote like elements having the same or similar functions.

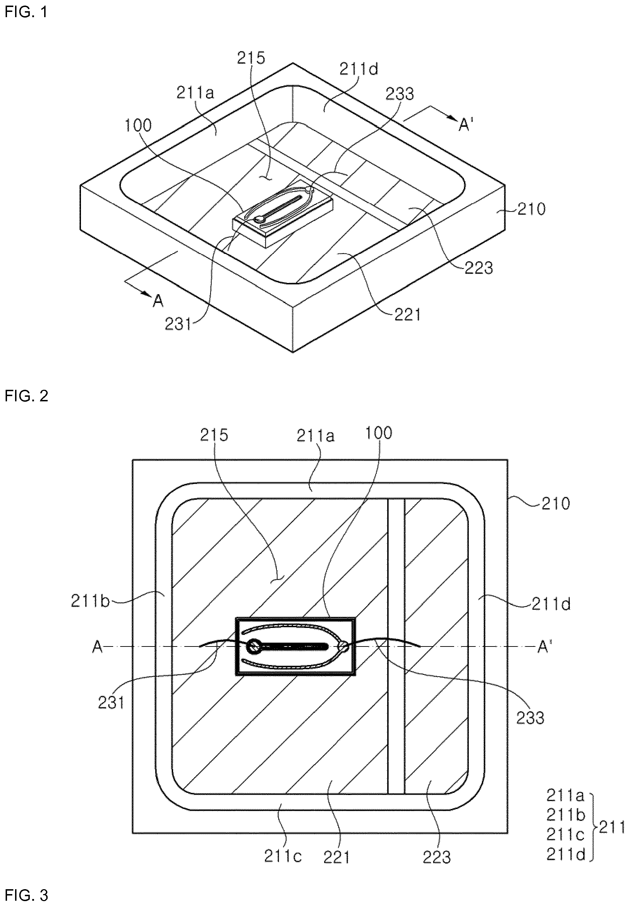

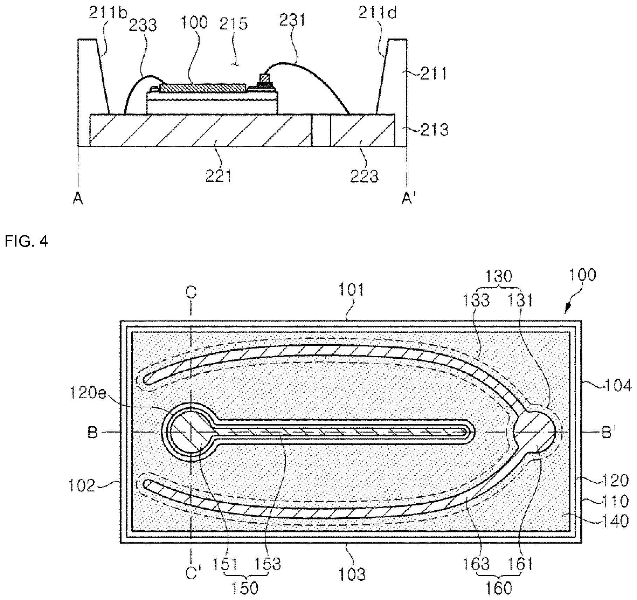

FIGS. 1 to 3 are a perspective view, a plan view, and a cross-sectional view illustrating a light emitting apparatus according to an exemplary embodiment of the present disclosure, respectively. FIGS. 4 to 6 are a plan view and cross-sectional views illustrating a light emitting device and light emitting apparatus according to an exemplary embodiment of the present disclosure, respectively. FIG. 3 illustrates a sectional view of a part corresponding to a line A-A' of FIGS. 1 and 2.

Referring to FIGS. 1 to 3, the light emitting apparatus may include a body 210 including a first lead frame 221 and a second lead frame 223, and at least one light emitting device 100. The light emitting apparatus may include at least one wiring 231 or 233.

The body 210 may provide a region on which the light emitting device 100 is arranged and, in the present embodiment, the body 210 may include the first lead frame 221 and the second lead frame 223 and, furthermore, include a base 213 and a side wall 211. In this case, the body 210 may include a cavity 215 that is surrounded by the side wall 211 and is open upward. A planar shape of the body 210 is not limited but, for example, may have an approximate square shape.

The side wall 211 may be positioned on the base 213 and may surround a partial space on the base 213 to provide a space in which the light emitting device 100 is mounted. The space may correspond to the cavity 215. The side wall 211 may include internal lateral surfaces and internal lateral surfaces of the side wall 211 may include a first side wall 211a, a second side wall 211b, a third side wall 211c, and a fourth side wall 211d. The first through fourth side walls 211a, 211b, 211c, and 211d may have substantially the same length but the present disclosure is not limited thereto. According to various exemplary embodiments of the present disclosure, the length of the first and third side walls 211a and 211c may be greater than the length of the second and fourth side walls 211b and 211 d. In addition, according to various exemplary embodiments of the present disclosure, when a planar form of the cavity 215 of the light emitting apparatus is a polygon, the number of internal lateral surfaces of the side wall 211 may be determined according to the number of sides of the polygon.

The first through fourth side walls 211a, 211b, 211c, and 211d may be inclined as illustrated in the drawings. Inclination of the first through fourth side walls 211a, 211b, 211c, and 211d may be adjusted in various ways in consideration of an orientation angle and others of the light emitting apparatus. Furthermore, the first through fourth side walls 211a, 211b, 211c, and 211d may include at least one of a flat surface, a concave surface, or a convex surface. The first through fourth side walls 211a, 211b, 211c, and 211d may be formed with different inclination angles that correspond to tangent line inclinations depending on an upward direction from a lower portion and and upper portion of a vertical sectional view of the apparatus.

The base 213 and the side wall 211 of the body 210 may be formed of an insulating material and may be formed of general plastic including polymer, acrylonitrile butadiene styrene (ABS), liquid crystalline polymer (LCP), polyamide (PA), polyphenylene sulfide (PPS), thermoplastic elastomer (TPE), or others, or ceramic. The base 213 and the side wall 211 may be formed of different materials or the same material. When the base 213 and the side wall 211 are formed of the same material, the base 213 and the side wall 211 may be integrally formed, as illustrated in the drawings. However, the present disclosure is not limited thereto and, thus, the base 213 and the side wall 211 may be formed of a metallic material and, in this case, to prevent electrical short circuit between the first and second lead frames 221 and 223, an insulating material may be further interposed between the lead frames 221 and 223 and the base 213 (and/or the side wall 211).

However, the present disclosure is not limited thereto and the body 210 may have any structure as long as the structure provides a region on which the light emitting device 100 is mounted. For example, the body 210 may not include a cavity.

The first lead frame 221 and the second lead frame 223 may be spaced apart from each other. The first and second lead frames 221 and 223 may be fixed by being at least partially surrounded by the base 213 and/or the side wall 211. At least a portion of the first lead frame 221 and at least a portion of the second lead frame 223 may be exposed in the cavity 215. The first and second lead frames 221 and 223 may be electrically connected to the light emitting device 100. For example, the light emitting device 100 and the lead frames 221 and 223 may be electrically connected to each other through the at least one wiring 231 or 233, which is described below in more detail.

In some embodiments, at least one of the first and second lead frames 221 and 223 may provide a region on which the light emitting device 100 is mounted. For example, as illustrated in the drawing, the light emitting device 100 may be mounted on the first lead frame 221 and, thus, the light emitting device 100 may be disposed in the cavity 215. The lead frames 221 and 223 may be formed of a material with electrical conductivity and may be formed with a single layer or multiple layers. For example, the lead frames 221 and 223 may include Cu, Ni, Au, Pt, Pd, Rh, W, Ti, Al, Mg, Ag, or others.

According to the present embodiment, although the case in which the light emitting apparatus includes the two lead frames 221 and 223 is described, the present disclosure is not limited thereto. According to another exemplary embodiment, the light emitting apparatus may include three or more lead frames and an electrical connection method (e.g., direct connection, parallel connection, and direct and parallel connection) between lead frames may be controlled to control an electrical connection method between light emitting diodes of a light emitting apparatus.

The light emitting device 100 may be positioned on the body 210. The light emitting device 100 may be arranged in the cavity 215 of the body 210 or may be mounted on the first lead frame 221. However, the present disclosure is not limited thereto. The light emitting device 100 may include a plurality of lateral surfaces and may include one lateral surface with a relatively long length and the other lateral surface with a shorter length than the one lateral surface.

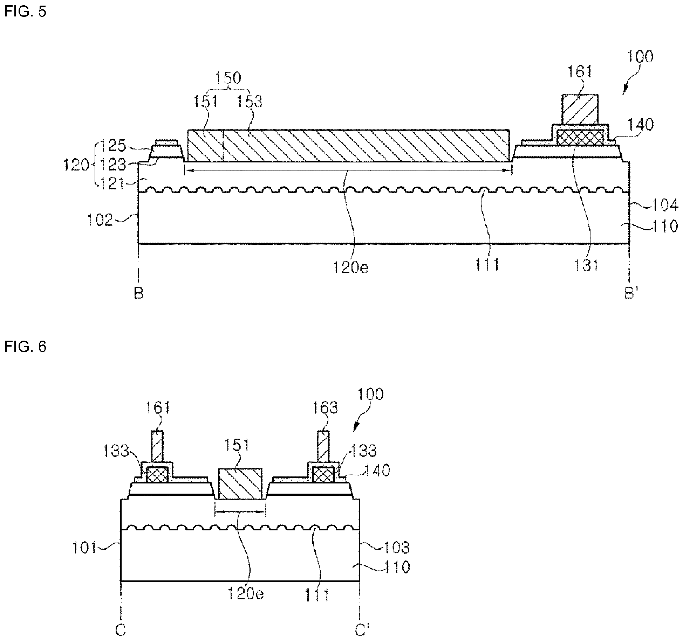

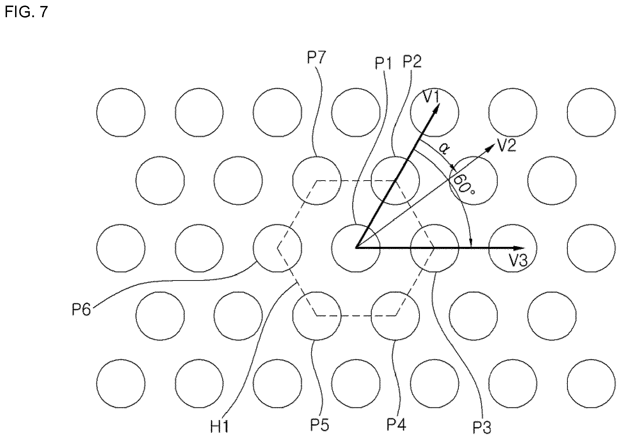

Hereinafter, with reference to FIGS. 4 to 6, the light emitting device 100 according to an exemplary embodiment of the present disclosure is described. With reference to FIGS. 7 to 12, arrangement with orientation of a plurality of protrusions 111 of a substrate 110 is described. In FIGS. 4 to 6, FIG. 5 is a cross-sectional view of a portion corresponding to a line B-B' of FIG. 4. FIG. 6 is a cross-sectional view of a portion corresponding to a line C-C' of FIG. 4.

Referring to FIGS. 4 to 6, the light emitting device 100 may include the substrate 110, a light emitting structure 120, a first electrode 150, and a second electrode 160. The light emitting device may further include a current blocking layer 130 and a transparent electrode 140. The light emitting device 100 may have an approximate rectangular planar shape. Accordingly, the light emitting device 100 may include a first lateral surface 101 and a third lateral surface 103 that have a relatively long length, and a second lateral surface 102 and a fourth lateral surface 104 that have a relatively short length.

The substrate 110 may be an insulating or conductive substrate. The substrate 110 may be a growth substrate for growing the light emitting structure 120 and may include a sapphire substrate, a silicon carbide substrate, a silicon substrate, a gallium nitride substrate, an aluminum nitride substrate, or others. The substrate 110 may include the plurality of protrusions 111 that are formed on at least a partial region of an upper surface thereof.

The plurality of protrusions 111 of the substrate 110 may be formed in regular patterns. For example, the plurality of protrusions 111 may be formed to configure a honeycomb pattern in which regular hexagons are repeatedly arranged. In detail, the plurality of protrusions 111 may be arranged with regular patterns that are arranged at central portions and vertexes of the regular hexagon. Accordingly, distances from a central portion of one protrusion 111 of the plurality of protrusions 111 to central portions of other six protrusions 111 adjacent to the one protrusion 111 may be materially the same. The protrusion 111 may have various shapes and may be formed like, for example, a circular cone, a cone, a polypyramid, a cylinder, or a polyprism.

According to an exemplary embodiment of the present disclosure, the substrate 110 may be a sapphire substrate and, in particular, may be a patterned sapphire substrate (PSS) with a patterned upper surface. The PSS may include the plurality of protrusions 111 formed on an upper surface thereof, the plurality of protrusions 111 may be arranged to form honeycomb patterns, and each of the protrusions 111 may have a conical shape or a circular conical shape. However, the present disclosure is not limited thereto and the substrate 110 may be a nitride-based substrate including the plurality of protrusions 111 formed on an upper surface thereof.

The plurality of protrusions 111 may be arranged with predetermined orientation. The orientation of the protrusion 111 may be defined based on a relationship with at least one of lateral surfaces of the light emitting device 100. For example, the orientation may be defined as three straight lines that extend from the center of one protrusion of the plurality of protrusions 111 to the centers of three of six protrusions adjacent to the one protrusion. In this case, the three straight lines may have an angle therebetween of 120°. An angle between at least one of the three straight lines and a relatively long lateral surface among lateral surfaces of the light emitting device 100 may be 15° to 45°. As such, the plurality of protrusions 111 may have predetermined orientation defined based on a relationship with one lateral surface of the light emitting device 100 to enhance the luminous efficiency of a light emitting device, which is described below in more detail.

Referring back to FIGS. 4 to 6, the light emitting structure 120 may be positioned on the substrate 110. Accordingly, the plurality of protrusions 111 may be positioned between the light emitting structure 120 and the substrate 110. The light emitting structure 120 may include a first conductivity type semiconductor layer 121, a second conductivity type semiconductor layer 125 positioned on the first conductivity type semiconductor layer 121, and an active layer 123 positioned between the first conductivity type semiconductor layer 121 and the second conductivity type semiconductor layer 125. The light emitting structure 120 may include an exposure region 120e through which the first conductivity type semiconductor layer 121 is exposed to be formed through at least a portion of the active layer 123 and the second conductivity type semiconductor layer 125.

The first conductivity type semiconductor layer 121, the active layer 123, and the second conductivity type semiconductor layer 125 may be grown and formed in a chamber using a known method such as MOCVD. The first conductivity type semiconductor layer 121, the active layer 123, and the second conductivity type semiconductor layer 125 may include a III-V-based nitride-based semiconductor and may include a nitride-based semiconductor, for example, (Al, Ga, In)N. The first conductivity type semiconductor layer 121 may include n-type impurities (e.g., Si, Ge, and Sn) and the second conductivity type semiconductor layer 125 may include p-type impurities (e.g., Mg, Sr, and Ba) or vice versa. The active layer 123 may include a multi quantum well structure (MQW) and a composition ratio of a nitride-based semiconductor may be adjusted to emit a desired wavelength. In particular, according to the present embodiment, the second conductivity type semiconductor layer 125 may be a p-type semiconductor layer.

The exposure region 120e may expose the first conductivity type semiconductor layer 121 therethrough to provide a region in which the first electrode 150 and the first conductivity type semiconductor layer 121 are electrically connected. Accordingly, the exposure region 120e may be formed to a position at which the first electrode 150 is to be arranged in consideration of current distribution, etc., of the light emitting device 100. For example, as shown in FIG. 4, the exposure region 120e may be formed to extend in a direction toward the fourth lateral surface 104 from a portion adjacent to the second lateral surface 102. According to various exemplary embodiments, the light emitting structure 120 may include a mesa including the second conductivity type semiconductor layer 125 and the active layer 123 and the exposure region 120e may be formed around the mesa.

The light emitting structure 120 may further include an uneven pattern (not shown) formed on at least a portion of a lateral surface thereof. Accordingly, the light extraction efficiency of the light emitting device may be enhanced.

The current blocking layer 130 may be at least partially positioned on the second conductivity type semiconductor layer 125. The current blocking layer 130 may be positioned on the second conductivity type semiconductor layer 125 to correspond to a position at which the second electrode 160 is positioned. The current blocking layer 130 may include a pad current blocking layer 131 and an extension current blocking layer 133. The pad current blocking layer 131 and the extension current blocking layer 133 may be positioned to correspond to positions of a second electrode pad 161 and a second electrode extension 163, respectively. Accordingly, as shown in the drawing, the pad current blocking layer 131 may be arranged adjacently to the fourth lateral surface 104 of the light emitting device and the plurality of extension current blocking layers 133 may be arranged to extend in a direction toward the second lateral surface 102 from the fourth lateral surface 104.

The current blocking layer 130 may prevent current supplied to the second electrode 160 from being transmitted directly to a semiconductor layer to be concentrated. Accordingly, the current blocking layer 130 may have insulation, may include an insulating material, and may be formed as a single layer or multiple layers. For example, the current blocking layer 130 may include SiOₓ or SiNₓ or may include a distributed Bragg reflector in which insulating material layers with different refractive indexes. The current blocking layer 130 may have optical transmittance, optical reflectivity, or selective optical reflectivity. The current blocking layer 130 may have a larger area than the second electrode 160 formed on the current blocking layer 130. Accordingly, the second electrode 160 may be positioned on a region in which the current blocking layer 130 is formed. Furthermore, the current blocking layer 130 may have a larger area than the second electrode 160 and, in this case, may have a planar shape that approximately corresponds to a planar shape of the second electrode 160. Accordingly, the current blocking layer 130 may prevent current supplied to the second electrode 160 from being transmitted directly to the first conductivity type semiconductor layer 121 through the transparent electrode 140 to be concentrated and, in this case, prevent light from being absorbed or reflected by the current blocking layer 130 to prevent reduction of luminous efficiency.

The transparent electrode 140 may be positioned on the second conductivity type semiconductor layer 125 and may cover at least a portion of an upper surface of the second conductivity type semiconductor layer 125 and at least a portion of the current blocking layer 130. The transparent electrode 140 may include a material with optical transmittance and electrical conductivity and, for example, may include at least one of conductive oxide layers such as ITO, ZnO, IZO, or GZO or optically transparent metallic layers such as Ni/Au. The transparent electrode 140 may form an ohmic contact with the second conductivity type semiconductor layer 125. The second electrode 160 does not directly contact the second conductivity type semiconductor layer 125 and, thus, current may be effectively distributed through the transparent electrode 140. The transparent electrode 140 may include a single layer or a multi layer. For example, the transparent electrode 140 may include a multilayer structure formed of ZnO.

The second electrode 160 may be positioned on the second conductivity type semiconductor layer 125 and, in this case, at least a portion of the second electrode 160 may be positioned on a region in which the current blocking layer 130 is positioned. The second electrode 160 may include the second electrode pad 161 and at least one second electrode extension 163 and the second electrode pad 161 and the second electrode extension 163 may be positioned on the pad current blocking layer 131 and the extension current blocking layer 133, respectively. Accordingly, a portion of the transparent electrode 140 may be interposed between the second electrode 160 and the current blocking layer 130.

The second electrode pad 161 and the second electrode extension 163 may be modified in different ways in consideration of current distribution. According to the present embodiment, the second electrode pad 161 may be arranged adjacently to the fourth lateral surface 104 and two second electrode extensions 163 may extend along a direction to the second lateral surface 102 from the fourth lateral surface 104. In this case, the second electrode extensions 163 may include a portion with curvature and, in particular, the second electrode extension 163 may include a portion in which a distance to the first lateral surface 101 (or the third lateral surface 103) from the second electrode extension 163 is reduced and a portion in which the distance is increased as the second electrode extension 163 extends to the second lateral surface 102 from the fourth lateral surface 104. Arrangement of the second electrode 160 is not limited thereto and may be modified and changed in various ways according to a shape of the light emitting device.

The first electrode 150 may be positioned on the first conductivity type semiconductor layer 121 and may be electrically connected to the first conductivity type semiconductor layer 121. The first electrode 150 may be positioned on the exposure region 120e, may ohmic-contact the first conductivity type semiconductor layer 121, and may be spaced apart from a lateral surface of the second conductivity type semiconductor layer 125 and a lateral surface of the active layer 123. The first electrode 150 may include a first electrode pad 151 and a first electrode extension 153. The first electrode pad 151 may be positioned adjacently to the second lateral surface 102. The first electrode extension 153 may extend from the first electrode pad 151 or may extend in a direction toward the fourth lateral surface 104 from the second lateral surface 102. At least a portion of the first electrode 150 may be disposed between the second electrode extension portions 163.

The first electrode 150 and the second electrode 160 may include a conductive material, may include a metallic material, for example, Ti, Pt, Au, Cr, Ni, Al, Mg, or the like, and may be formed with a single layer or multi layer structure. When the first electrode 150 and the second electrode 160 are formed with multiple layers, the first electrode 150 and the second electrode 160 may include at least one of metallic stack structures of Ti layer/Au layer, Ti layer/Pt layer/Au layer, Cr layer/Au layer, Cr layer/Pt layer/Au layer, Ni layer/Au layer, Ni layer/Pt layer/Au layer, or Cr layer/AI layer/Cr layer/Ni layer/Au layer. However, the present disclosure is not limited thereto.

A light emitting device according to some embodiments may further include a passivation layer (not shown) which at least partially covers a surface of the light emitting device. The passivation layer may protect the light emitting device from external moisture or harmful gas. The passivation layer may be formed of an insulating material or may include a single layer or multiple layers. For example, a passivation layer may include SiO₂, MgF₂, SiN, or the like or may include a distributed Bragg reflector in which different material layers such as TiO₂ and SiO₂ are repeatedly stacked. When the passivation layer includes a multi layer, an uppermost layer may be formed of SiN and, in this case, SiN has high moisture tolerance to effectively protect the light emitting device from external moisture.

Hereinafter, arrangement with orientation of the plurality of protrusions 111 of the substrate 110 is described in more detail with reference to FIGS. 7 to 12.

First, referring to FIG. 7, methodology for defining orientation of the plurality of protrusions 111 according to exemplary embodiments of the present disclosure is described.

Referring to FIG. 7, when the plurality of protrusions 111 are arranged in a honeycomb pattern, the plurality of protrusions 111 may include first to seventh protrusions P1 to P7. With respect to the first protrusion P1, the second to seventh protrusions P2 to P7 may be arranged around the first protrusion P1. A central portion of the first protrusion P1 may be positioned at a central portion of an imaginary hexagon H1 and central portions of the second to seventh protrusions P2 to P7 may be positioned at vertexes of the imaginary hexagon H1, respectively.

A vector line that extends in a direction toward the center of the second protrusion P2 from the center of the first protrusion P1 may be defined as a first vector line V1 and a vector line that extends in a direction toward the center of the third protrusion P3 from the center of the first protrusion P1 may be defined as a third vector line V3. In this case, an angle between the first vector line V1 and the third vector line V3 may be 60°. When the plurality of protrusions 111 are arranged in a honeycomb pattern as illustrated in the drawings, both the first vector line V1 and the third vector line V3 pass through centers of adjacent protrusions, and thus, orientation of protrusions arranged along the first vector line V1 may be materially the same as orientation of protrusions arranged along the third vector line V3.

Accordingly, with regard to such protrusions arranged in a honeycomb pattern, when a vector line with an angle difference of α formed with respect to the first vector line V1 is defined as a second vector line V2, orientation of protrusions arranged along the second vector line V2 may be changed depending on angle α between the first vector line V1 and the second vector line V2. When α is 60°, the second vector line V2 has the same direction as the third vector line V3 and, in this case, orientation of protrusions arranged in a direction toward the second vector line V2 may be the same as orientation of protrusions arranged in a direction toward the first vector line V1. When angle α between the first vector line V1 and the second vector line V2 has a value between 0 and 60°, orientation of protrusions arranged along the second vector line V2 may be different from orientation of protrusions arranged in a direction toward the first vector line V1.

When angle α has a value exceeding 0° and below 60°, linear density of a protrusion per unit length of the first vector line V1 may be different from linear density of a protrusion per unit length of the second vector line V2. For example, referring to FIG. 7, when a length of the first vector line V1 and the second vector line V2 is defined as 1, linear density of a protrusion per unit length of the first vector line V1 may be about 2 and linear density of a protrusion per unit length of the second vector line V2 may be about 1. From such an approach method, linear density of a protrusion per unit length of the second vector line V2 may be changed depending on angle α (0<α<60°). When protrusions are arranged along the first vector line V1, the protrusions are most densely arranged and, thus, linear density of a protrusion per unit length of the second vector line V2 may be smaller than linear density of a protrusion per unit length of the first vector line V1.

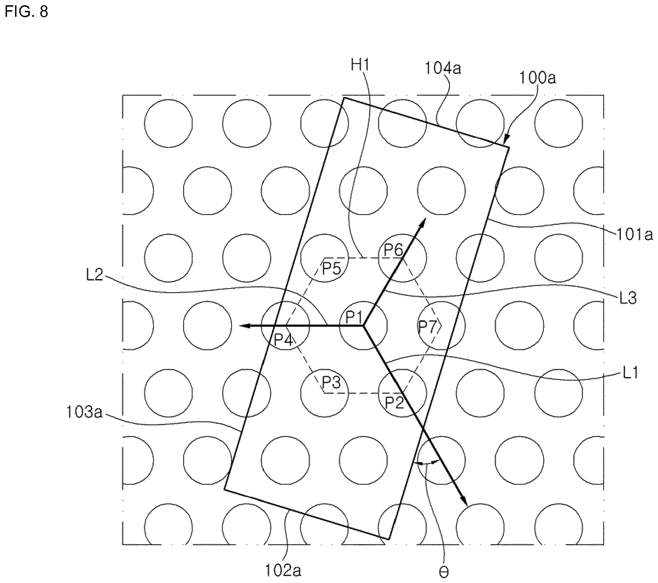

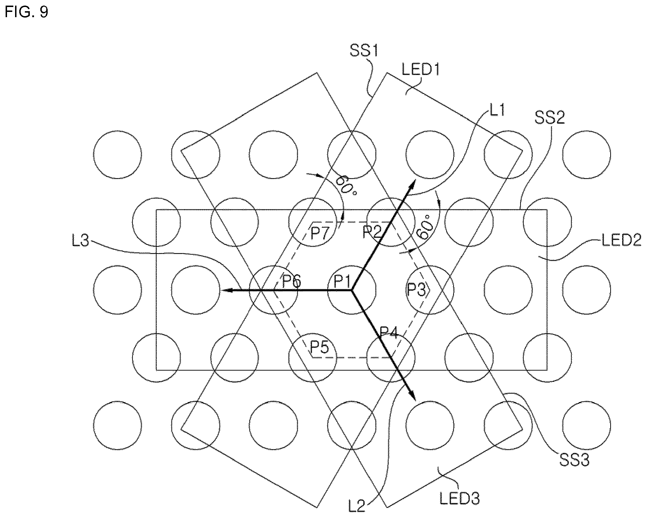

With reference to FIGS. 8 and 9, based on the methodology, orientation of the protrusions 111 of the light emitting device 100 will be described in more detail.

First, referring to FIG. 8, the protrusions 111 of the substrate 110 may be formed along a honeycomb pattern. The plurality of protrusions 111 may include the first to seventh protrusions P1 to P7. With respect to the first protrusion P1, which can be any one of the plurality of protrusions 111, the second to seventh protrusions P2 to P7 may be arranged around the first protrusion P1. A central portion of the first protrusion P1 may be positioned at a central portion of an imaginary hexagon H1 and central portions of the second to seventh protrusions P2 to P7 may be positioned at vertexes of the imaginary hexagon H1, respectively.

A vector line that extends in a direction toward the center of the second protrusion P2 from the center of the first protrusion P1 may be defined as a first vector line L1, a vector line that extends in a direction toward the center of a fourth protrusion P4 from the center of the first protrusion P1 may be defined as a second vector L2, and a vector line that extends in a direction toward the center of a sixth protrusion P6 from the center of the first protrusion P1 may be defined as a third vector line L3. In this case, an angle between the first vector line L1 and the second vector L2 may be 120° and an angle between the second vector L2 and a third vector line L3 may also be 120°.

As such, when a direction based on the first to third vector lines L1, L2, and L3 is defined, an angle between at least one of the first to third vector lines L1, L2, and L3 and a relatively long lateral surface of the light emitting device 100 may be defined as θ. In detail, referring to FIG. 8, the reference number 100a in FIG. 8 is shown to indicate a similar figure to a planar shape of the light emitting device 100 and 101a, 102a, 103a, and 104a are parallel lines to the first lateral surface 101, the second lateral surface 102, the third lateral surface 103, and the fourth lateral surface 104 of the light emitting device 100, respectively. Here, an angle between the first vector line L1 and the parallel line 101a to the first lateral surface 101 with a relatively long lateral surface may be defined as θ.

θ may be an angle in the range of 0 to 60°. As previously described with reference to FIG. 7, with regard to protrusions arranged in a honeycomb pattern, angle α between the first vector line V1 and the second vector line V2 is 0, 60°, 120°, 180°, 240°, 300°, or 360°, orientation of protrusions arranged along the first vector line V1 may be the same as orientation of protrusions arranged along the second vector line V2. Similarly, in FIG. 8, when an angle between a vector line of at least one of the first to third vector lines L1, L2, and L3 and a relatively long lateral surface of the light emitting device 100 is θ, orientation of protrusions may be the same as orientation of protrusions when 60° is added to θ. For example, orientation of protrusions when θ is 12° is the same as orientation of protrusions when θ is 72°.

Referring to FIG. 9, LED 1, LED 2, and LED 3 are similar figures to planar shapes of light emitting devices with the same planar shape. SS1, SS2, and SS3 are relatively long lateral surfaces of LED 1, LED 2, and LED 3, respectively. As illustrated in the drawing, lower protrusions of LED 1, LED 2, and LED 3 may be arranged with the same orientation with respect to LED 1, LED 2, and LED 3, respectively. In this case, an angle between a lateral surface SS1 of LED 1 and a lateral surface SS2 of LED 2 may be 60° and an angle between the lateral surface SS2 of LED 2 and a lateral surface SS3 of LED 3 may be 60°. When a light emitting device is rotated based on the first protrusion P1 by 60°, lower protrusions of the light emitting device may have the same orientation.

Accordingly, an angle θ between at least one of the first to third vector lines L1, L2, and L3 and a relatively long lateral surface of the light emitting device 100 may be in the range of 0 to 60°. According to exemplary embodiments of the present disclosure, the angle θ may be equal to or greater than about 15° and equal to or less than about 45° and, in particular, θ may be about 30°. Orientation of protrusions may be controlled in such a way that θ is equal to or greater than about 15° and equal to or less than 45° to enhance the luminous efficiency of a light emitting device. Linear density of a protrusion per unit length of at least one of the first to third vector lines L1, L2, and L3 may be greater than linear density of a protrusion per unit length of a parallel line to a relatively long lateral surface (the first lateral surface 101 or the third lateral surface 103) of the light emitting device 100.

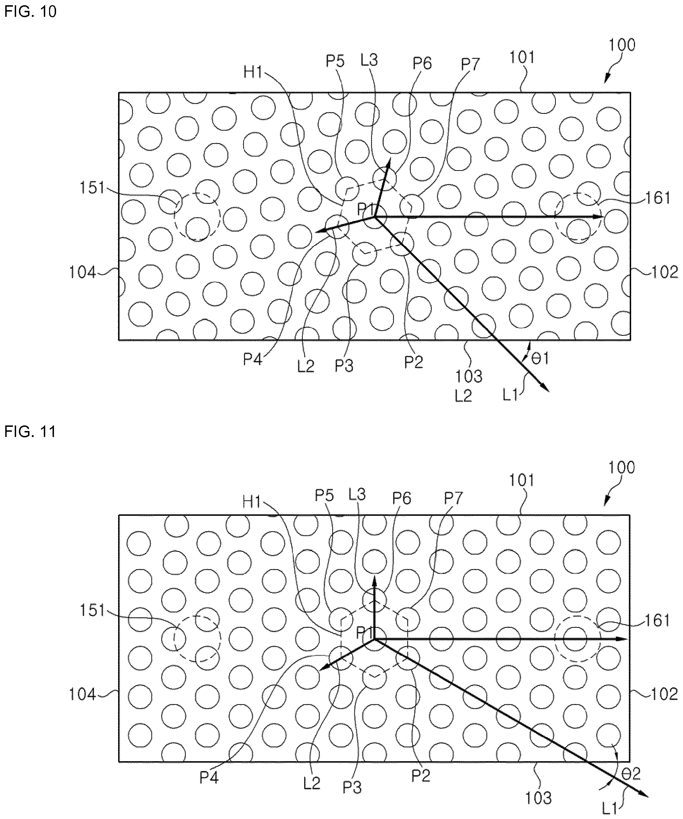

FIGS. 10 and 11 are schematic diagrams illustrating orientation of protrusions 111 according to exemplary embodiments. FIGS. 10 and 11 show arrangement and orientation of the protrusions 111 based on a planar shape of the light emitting device 100. However, the number, size, and density of the protrusions 111 are not limited thereto and, the size of the protrusions 111 is exaggerated for convenience of description.

First, referring to FIG. 10, an angle between at least one of the first to third vector lines L1, L2, and L3 and a relatively long lateral surface (the first lateral surface 101 or the third lateral surface 103) of the light emitting device 100 may be θ1 (15°<θ1<45°). According to the present embodiment, as illustrated in the drawing, an angle between the first vector line L1 and the third lateral surface 103 may be defined as θ1. In this case, θ1 may be about 45°. In this case, linear density of a protrusion per unit length of the first vector line L1 may be greater than linear density of a protrusion per unit length of the arbitrary parallel line 103a to the third lateral surface 103.

Similarly, referring to FIG. 11, an angle between at least one of the first to third vector lines L1, L2, and L3 and a relatively long lateral surface (the first lateral surface 101 or the third lateral surface 103) of the light emitting device 100 may be θ2 (15°<θ2<45°). According to the present embodiment, as illustrated in the drawing, an angle between the first vector line L1 and the third lateral surface 103 may be defined as θ2. In this case, θ2 may be about 30°. In this case, linear density of a protrusion per unit length of the first vector line L1 may be greater than linear density of a protrusion per unit length of the arbitrary parallel line 103a to the third lateral surface 103.

As such, orientation of protrusions may be determined in such a way that θ is in the range of about 15° to 45° to enhance the luminous efficiency of the light emitting device 100. When θ has an angle in this range, linear density of protrusions per unit length in a relatively long lateral surface of the light emitting device 100 may be reduced. As the linear density of protrusions per unit length in a lateral surface is reduced, light extraction efficiency through the lateral surface may be enhanced. According to the present embodiment, in the case of the light emitting device 100 with a relatively long lateral surface and a relatively short lateral surface, emission through a relatively long lateral surface may be greater than emission through a relatively short lateral surface. Accordingly, linear density of protrusions per unit length in a relatively long lateral surface (e.g., the first lateral surface 101 and the third lateral surface 103) may be reduced to increase overall emission of the light emitting device.

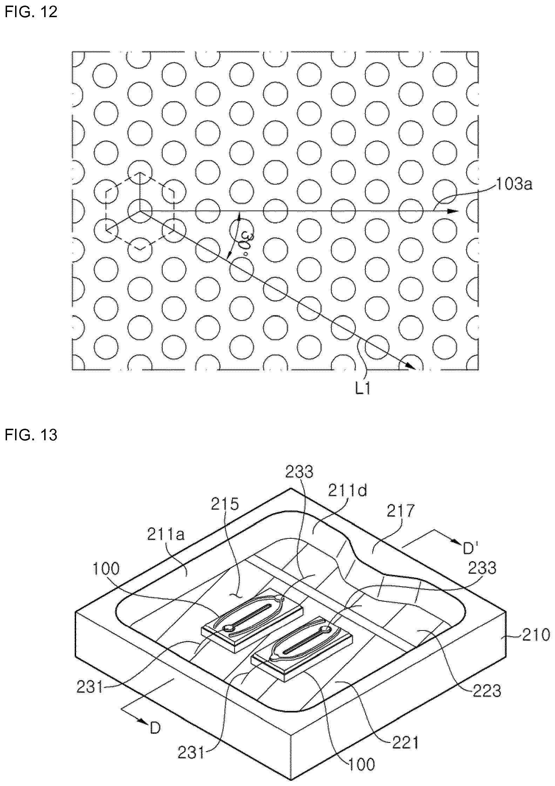

In particular, when θ is 30°, linear density of protrusions per unit length in a relatively long lateral surface (e.g., the first lateral surface 101 and the third lateral surface 103) may be minimized to significantly enhance luminous efficiency. As illustrated in FIGs. 7 and 12, when an angle between the second vector line V2 and the first vector line V1 is 30°, linear density of a protrusion per unit length of the second vector line V2 may be minimized. Accordingly, in this case, emission in a relatively long lateral surface (e.g., the first lateral surface 101 and the third lateral surface 103) may be further increased to enhance luminous efficiency of the light emitting device. In addition, emission in a relatively long lateral surface (e.g., the first lateral surface 101 and the third lateral surface 103) may be increased to increase an oriented angle of the light emitting device 100.

Referring back to FIGS. 1 to 3, the light emitting device 100 may be electrically connected to the first and second lead frames 221 and 223 through the at least one wiring 231 or 233.

At least one wiring 231 or 233 may connect at least one of the first electrode 150 and the second electrode 160 to at least one of the first and second lead frames 221 and 223. In this case, the at least one wiring 231 or 233 may be positioned above a relatively short lateral surface of the light emitting device 100. For example, as illustrated in FIGS. 1 to 3, a second wiring 233 may connect the second electrode pad 161 of the light emitting device 100 to the second lead frame 223 and, in this case, the second wiring 233 may extend through an upper space of the fourth lateral surface 104 of the light emitting device 100. Accordingly, a portion of the second wiring 233 may be positioned above the fourth lateral surface 104 of the light emitting device 100. Similarly, a first wiring 231 may connect the first electrode pad 151 of the light emitting device 100 to the first lead frame 221 and, in this case, the first wiring 231 may extend through an upper space of the second lateral surface 102 of the light emitting device 100. Accordingly, a portion of the first wiring 231 may be positioned above the second lateral surface 102 of the light emitting device 100.

As such, at least one wiring 231 and 233 may extend through an upper space through a relatively short lateral surface of the light emitting device 100 and, in this case, may not be positioned in an upper space of a relatively long lateral surface of the light emitting device 100. As described above, the light emitting device 100 may include the protrusion 111 with predetermined orientation and, thus, emission transmitted through a relatively long lateral surface (the first lateral surface 101 and the third lateral surface 103) may be increased or maximized. In this case, at least one wiring 231 or 233 may be positioned only above a relatively short lateral surface (the second lateral surface 102 and the fourth lateral surface 104) and may not be positioned above a relatively long lateral surface (the first lateral surface 101 and the third lateral surface 103). Accordingly, emission emitted from a relatively short lateral surface is smaller than emission emitted from a relatively long lateral surface and, thus, emission absorbed and lost through the wirings 231 and 233 may be minimized. In addition, optical loss due to the wirings 231 and 233 may be minimized with respect to light emitted from a relatively long lateral surface. Accordingly, the luminous efficiency of a light emitting apparatus may be further enhanced.

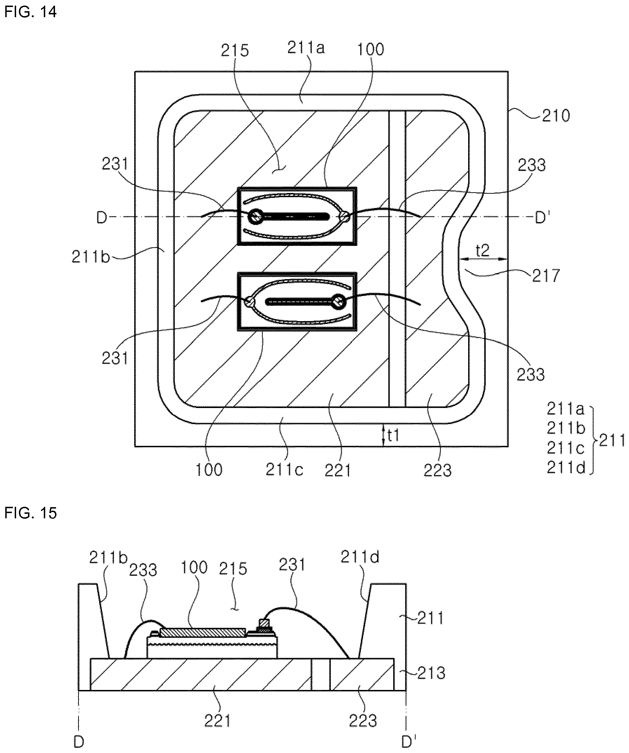

FIGS. 13 to 15 are a perspective view, a plan view, and a cross-sectional view illustrating a light emitting apparatus according to another exemplary embodiment of the present disclosure. FIG. 15 is a cross-sectional view of a portion corresponding to a line D-D' of FIGS. 13 and 14. The light emitting apparatus according to the present embodiment is different from the light emitting apparatus of FIGS. 1 to 6 in that the light emitting apparatus according to the present embodiment includes the plurality of light emitting devices 100 and the body 210 further includes a protrusion portion 217. Hereinafter, the light emitting apparatus according to the present embodiment is described in terms of the difference and a description of the same configuration is omitted.

The light emitting apparatus may include the body 210 including the first lead frame 221 and the second lead frame 223 and the plurality of light emitting devices 100. The light emitting apparatus may include the at least one wiring 231 or 233.

The plurality of light emitting devices 100 may be arranged in the cavity 215 of the body 210. In addition, relatively long lateral surfaces of the plurality of light emitting devices 100, for example, the first lateral surface 101 and the third lateral surface 103 of the light emitting device 100 may be arranged in parallel to each other. As such, relatively long lateral surfaces (the first lateral surface 101 and the third lateral surface 103) of the plurality of light emitting devices 100 may be arranged approximately parallel to each other and, thus, the wirings 231 and 233 may not be positioned through an upper portion of a relatively long lateral surface. Accordingly, the luminous efficiency of a light emitting apparatus including the plurality of light emitting devices 100 may be further enhanced.

The plurality of light emitting devices 100 may have various electrical connection shapes and, for example, as illustrated in the drawing, may be connected in series to each other. However, the present disclosure is not limited thereto and the plurality of light emitting devices 100 may be electrically connected in parallel or in series and parallel to each other.

The body 210 may further include the protrusion portion 217 that protrudes toward a central portion from an internal wall in the cavity 215. The protrusion portion 217 may protrude toward a space between the plurality of light emitting devices 100. For example, as illustrated in the drawing, the protrusion portion 217 may protrude from the fourth side wall 211d and may protrude toward a space between the plurality of light emitting devices 100. A surface of the protrusion portion 217 may include a curved surface and/or a flat surface. A thickness t2 of the protrusion portion 217 may be greater than a thickness of another portion t1 of the side wall 211. Accordingly, a thickness of the protrusion portion 217 may be greater than an average thickness of the side wall 211.

The body 210 includes the protrusion portion 217 and, thus, light emitted from the second lateral surface 102 (or the fourth lateral surface 104) of the light emitting device 100 may be scattered and distributed through the protrusion portion 217. Accordingly, light emitted from the second lateral surface 102 (or the fourth lateral surface 104) of the light emitting device 100 may be prevented from being reflected off the fourth side wall 211d and being again incident and lost on the light emitting device 100 or being lost by the wirings 231 and 233.

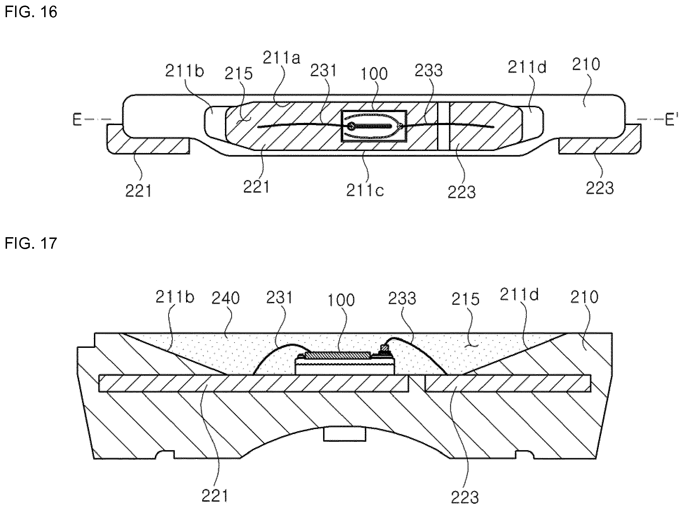

FIGS. 16 and 17 are a plan view and a cross-sectional view illustrating a light emitting apparatus according to another exemplary embodiment of the present disclosure. Here, FIG. 17 is a cross-sectional view of a portion corresponding to a line E-E' of FIG. 16. The light emitting apparatus according to the present embodiment is different from the light emitting apparatus of FIGS. 1 to 6 in terms of a side view light emitting apparatus. Hereinafter, the light emitting apparatus according to the present embodiment is described in terms of the difference and a description of the same configuration is omitted.

Referring to FIGS. 16 and 17, the light emitting apparatus may include the body 210 including the first lead frame 221 and the second lead frame 223, and the light emitting device 100. The light emitting apparatus may include the at least one wiring 231 and 233 and include a sealing member 240.

According to the present embodiment, the body 210 may have the cavity 215 surrounded by the first side wall 211a, the second side wall 211b, the third side wall 211c, and the fourth side wall 211d. The cavity 215 of the body 210 may have a relatively long shape. That is, the first side wall 211a and the third side wall 211c may be longer than the second and fourth side walls 211b and 211d. The first side wall 211a and the third side wall 211c may be more drastically inclined than the second and fourth side walls 211b and 211d.

The light emitting device 100 may be arranged in the relatively long cavity 215 of the body 210. For example, the light emitting device 100 may be arranged in the cavity 215 in such a way that a length direction of the light emitting device 100 corresponds to a length direction of the cavity 215. Thus, a relatively long lateral surface of the light emitting device 100, that is, first and third lateral surfaces of the light emitting device 100 may be arranged approximately parallel to the relatively long first side wall 211a and the relatively long third side wall 211c of the body 210 that surrounds the cavity 215.

The first side wall 211a and the third side wall 211c may be more drastically inclined than the second side wall 211b and the fourth side wall 211d. Among side walls surrounding the cavity 215, the first and third side walls 211a and 211c occupy most of the side walls and, thus, it may be particularly important to control light emitted toward the first and third side walls 211a and 211c. The first and third side walls 211a and 211c are drastically inclined and, thus, when a large amount of light is emitted to the side walls 211a and 211c, enhancement in luminous efficiency of the light emitting apparatus may be adversely affected. According to the present embodiment, the long light emitting device 100 may be arranged to correspond to a length direction of the cavity 215 and linear density of the protrusions 111 positioned on the first and third lateral surfaces of the light emitting device 100 may also be reduced and, thus, light emitted to the first and third side walls 211a and 211c may be controlled to enhance luminous efficiency of the light emitting apparatus.

The wirings 231 and 233 may be arranged across upper portions of relatively short lateral surfaces (second and fourth lateral surfaces) of the light emitting device 100 and, thus, the luminous efficiency of the light emitting apparatus including the light emitting device 100 may be further enhanced.

The sealing member 240 may cover the light emitting device 100 and the wirings 231 and 233 and may be filled in the cavity 215. The sealing member 240 may be formed of a transparent resin, for example, epoxy or silicon resin and may include a phosphor to convert a wavelength of light emitted from the light emitting device 100.

### (Experimental Example)

Only orientation of the protrusions 111 of the substrate 110 was changed to manufacture a light emitting device and a light emitting apparatus and emission power and luminous flux thereof were examined. Here, the side view light emitting apparatus described with reference to FIGS. 16 and 17 was used as the light emitting apparatus. A light emitting device according to a comparative example includes protrusions 111 with orientation at an angle of 60° between at least one of the first to third vector lines L1, L2, and L3 and a relatively long lateral surface (the first lateral surface 101) of the light emitting device and a light emitting device according to an exemplary embodiment of the present disclosure includes protrusions 111 with orientation at an angle of 30° between at least one of the first to third vector lines L1, L2, and L3 and a relatively long lateral surface (the first lateral surface 101) of the light emitting device.

An emission wavelength and emission power were measured with respect to 800 light emitting devices formed around the center in each of wafers according to the comparative example and the exemplary embodiment and luminous flux of a white side view light emitting apparatus (Cx=0.2997) manufactured using 20 light emitting devices thereamong was measured. Emission power of a light emitting device was measured at a central axis of an emissive surface of the light emitting device and luminous flux of the side view light emitting apparatus was measured with respect to light emitted in all directions from the light emitting apparatus using an integrating sphere.

Emission wavelengths of the light emitting devices according to the comparative example and the exemplary embodiment had similar values about 446 nm. The emission power of the light emitting device according to the exemplary embodiment was enhanced by about 1.07% compared with the emission power of the light emitting device according to the comparative example. It is seen that orientation of the protrusions 111 is changed to enhance light output emitted toward an upper surface of the light emitting device.

The luminous flux of the light emitting apparatus according to the exemplary embodiment was enhanced by 0.46% compared with luminous flux of the light emitting device according to the comparative example. In consideration of influence of a sealing member including a phosphor, enhancement in luminous flux according to the exemplary embodiment is estimated to be significantly meaningful.

Although the various exemplary embodiments of the present disclosure are described with respect to respective drawings, the exemplary embodiments may be embodied in many different forms. The components according to the exemplary embodiments may be applied to other exemplary embodiments without departing from the teachings of the present disclosure.

## Claims

1. A light emitting device comprising a first lateral surface and a second lateral surface with a shorter length than the first lateral surface, comprising:
a substrate comprising a plurality of protrusions formed on an upper surface thereof; and
a light emitting structure disposed on the substrate and comprising a first conductivity type semiconductor layer, a second conductivity type semiconductor layer, and an active layer disposed between the first and second conductivity type semiconductor layers,
wherein the plurality of protrusions is arranged in a honeycomb pattern of protrusions and comprises a first protrusion and second to seventh protrusions adjacent to the first protrusion and spaced apart from the first protrusion by a same distance;
wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line;
wherein an angle between the first vector line and the second vector line is 120° and an angle between the second vector line and the third vector line is 120°; and
wherein an angle θ between at least one of the first to third vector lines and the first lateral surface is equal to or greater than 15° and equal to or less than 45°.

2. The light emitting device of claim 1, wherein the angle θ is 30°.

3. The light emitting device of claim 1, wherein the protrusions in the plurality of protrusions have a conical shape with a circular lower surface or a circular conical shape.

4. The light emitting device of claim 1, wherein a linear density of protrusions per unit length of the first to third vector lines is greater than a linear density of protrusions per unit length of an arbitrary parallel line to the first lateral surface.

5. The light emitting device of claim 1, further comprising a first electrode electrically connected to the first conductivity type semiconductor layer and a second electrode electrically connected to the second conductivity type semiconductor layer.

6. The light emitting device of claim 5, wherein the first electrode comprises a first electrode pad and the second electrode comprises a second electrode pad; and
wherein one of the first electrode pad and the second electrode pad is positioned adjacently to the second lateral surface.

7. The light emitting device of claim 1, wherein the light emitting device has a rectangular planar shape.

8. The light emitting device of claim 1, wherein the substrate comprising the protrusions is a patterned sapphire substrate.

9. A light emitting apparatus comprising:
a body comprising a base and a side wall;
first and second lead frames fixed to the body; and
a light emitting device disposed on the base and comprising a first lateral surface and a second lateral surface with a shorter length than the first lateral surface,
wherein the light emitting device comprises,
a substrate comprising a plurality of protrusions formed on an upper surface of the substrate, and
a light emitting structure disposed on the substrate and comprising a first conductivity type semiconductor layer, a second conductivity type semiconductor layer, and an active layer disposed between the first and second conductivity type semiconductor layers;
wherein the plurality of protrusions is arranged in a honeycomb pattern and comprises a first protrusion and second to seventh protrusions adjacent to the first protrusion and spaced apart from the first protrusion by a same distance;
wherein a vector line that extends in a direction toward a center of the second protrusion from a center of the first protrusion is defined as a first vector line, a vector line that extends in a direction toward a center of the fourth protrusion from the center of the first protrusion is defined as a second vector line, and a vector line that extends in a direction toward a center of the sixth protrusion from the center of the first protrusion is defined as a third vector line;
wherein an angle between the first vector line and the second vector line is 120° and an angle between the second vector line and the third vector line is 120°; and
wherein an angle θ between at least one of the first to third vector lines and the first lateral surface is equal to or greater than 15° and equal to or less than 45°.

10. The light emitting apparatus of claim 9, wherein the angle θ is 30°.

11. The light emitting apparatus of claim 9, wherein linear density of protrusions per unit length of the first to third vector lines is greater than linear density of protrusions per unit length of an arbitrary parallel line to the first lateral surface.

12. The light emitting apparatus of claim 9, wherein the light emitting device further comprises a first electrode electrically connected to the first conductivity type semiconductor layer and a second electrode electrically connected to the second conductivity type semiconductor layer;
wherein the first electrode comprises a first electrode pad and the second electrode comprises a second electrode pad; and
wherein one of the first electrode pad and the second electrode pad is positioned adjacently to the second lateral surface.

13. The light emitting apparatus of claim 12, further comprising a wiring configured to electrically connect at least one of the first and second electrode pads to at least one of the first and second lead frames.

14. The light emitting apparatus of claim 13, wherein the wiring extends toward one of the first and second lead frames from one of the first and second electrode pads; and
wherein the wiring extends through an upper space of the second lateral surface.

15. The light emitting apparatus of claim 9, wherein the light emitting apparatus comprises a plurality of light emitting devices; and
wherein a first lateral surface of one of the plurality of light emitting devices and a first lateral surface of another one of the plurality of light emitting devices are arranged in parallel to each other.

16. The light emitting apparatus of claim 15, wherein the side walls comprise a protrusion that protrudes toward a central portion of the body; and
wherein the protrusion protrudes toward a space between the plurality of light emitting devices.

17. The light emitting apparatus of claim 9, wherein the body has a long cavity surrounded by the side walls; and
wherein the first lateral surface of the light emitting device is arranged in a length direction of the cavity.

18. The light emitting apparatus of claim 17, wherein the side walls of the body comprise relatively long first and third side walls and relatively short second and fourth side walls; and
wherein an inclination of the first and third side walls is sharper than an inclination surface of the second and fourth side walls.
